# EUROPEAN PATENT SPECIFICATION

(11) **EP 2 854 190 B1**
(45) Date of publication and mention of the grant of the patent: **25.05.2016**
(21) Application number: 13186629.5
(22) Date of filing: 30.09.2013
(51) Int. Cl.: H01L 35/30

(54) **Thermoelectric generator**
Thermoelektrischer Generator
Générateur thermoélectrique

(43) Date of publication of application: 01.04.2015
(73) Proprietor: Airbus Defence and Space GmbH, 85521 Ottobrunn (DE)
(72) Inventor: Elefsiniotis, Alexandros, 81375 München (DE); Kokorakis, Nikolaos, 81375 München (DE); Becker, Thomas, 27711 Osterholz-Scharmbeck (DE); Schmid, Ulrich, 1140 Wien (AT)
(74) Representative: Rasch, Michael

(56) References cited:
- EP-A2- 2 475 019
- EP-A2- 2 482 352
- DE-A1-102009 038 925
- US-A1- 2012 073 276
- US-B1- 7 262 360
- D. SAMSON ET AL: "Aircraft-Specific Thermoelectric Generator Module", JOURNAL OF ELECTRONIC MATERIALS, vol. 39, no. 9, 1 September 2010 (2010-09-01), pages 2092-2095, XP055071269, ISSN: 0361-5235, DOI: 10.1007/s11664-009-0997-7

## Description

The invention relates to a device for generating electrical energy comprising at least a thermoelectric generator arranged between a surface subjected to thermal exposure and a container containing a phase change material.

It is known to generate energy using thermoelectric generators which are devices that convert a temperature gradient between two surfaces directly into electrical energy, using the so-called "Seebeck effect". One of these surfaces is subjected to thermal exposure such as high or low temperature. For example, it is possible to attach one side of a thermoelectric generator to an aircraft fuselage which is exposed to the ambient temperature of the aircraft. On the ground, this temperature is more or less the air temperature on the ground. During flight, the ambient temperature may be between -20°C and - 50°C depending on the flight conditions. If the other surface of the thermoelectric generator is thermoconductively connected to a container containing a phase change material such as water, the temperature gradient between the outside and the phase change material can be converted into electric energy. For example, if the outside temperature is -20°C and the temperature of the phase change material is +20°C, the phase change material will cool to the phase change point (freezing point) of the phase change material, namely 0°C in the case of water, and remain at this temperature until all of the phase change material is solidified or frozen. During this time, a constant electrical energy flow can be achieved. After all of the phase change material is frozen, its temperature will approach the outside temperature while at the same time due to the decreasing temperature gradient between the two sides of the thermoelectric generator, the electrical current will decrease and will reach a value close to 0. Afterwards, if the outside temperature rises again, the same effect can be achieved only in that the temperature difference is opposite and, thus, the current flows in the opposite direction

DE 10 2009 038925A1 discloses a device for generating electrical energy according to the preamble of claim 1, comprising at least a first thermoelectric generator arranged between a surface subjected to thermal exposure and a container containing a phase change material, the container being surrounded by at least one heat conducting element.

It is object of the present invention to provide a device for generating electrical energy comprising at least a first thermoelectric generator arranged between a surface subjected to thermal exposure and a container containing a phase change material which improves overall efficiency by avoiding energy losses to the surroundings of the device.

This object is solved by the invention as set out in claim 1. Advantageous embodiments are set out in the dependent claims.

More specifically, said container is surrounded by at least one heat conducting element which is thermoconductively connected to said surface and which is thermoconductively connected to the circumference of said container through plural thermoelectric generators.

This arrangement allows the temperature gradient between the surface subjected to thermal exposure and the phase change material to be fully utilized as almost any heat flow from the phase change material is converted to electrical energy improving the efficiency of the device. Thus, the overall efficiency of the device is increased by avoiding waste heat flux and by increasing the contact area of the thermoelectric generators with the phase change material.

According to a preferred embodiment of the invention, said phase change material contains water. Water is especially useful if the temperature range of the thermal exposure includes the phase change (melting) point of water, i.e. 0°C. For example, if the temperature of the surface subjected to thermal exposure is between -20°C and +20°C, water is an ideal phase change material. If, on the other hand, the temperature range of the thermal exposure does not include 0°C - for example if an aircraft is operated only in cold regions such as the Antarctic - other phase change materials which have a phase change point within this temperature range should be used. Such other phase change materials preferably contain water and other substances which reduces the freezing point of water.

According to a preferred embodiment of the invention, the heat conducting element comprises a plate or plate-like structure, which is made of a material with a high thermal conductivity.

According to another preferred embodiment of the invention, the heat conducting element surrounds said container. Especially, the plate is shaped as a container more or less totally surrounding the container with the phase change material. The whole inner surface of this plate or container should be occupied by thermoelectric generators.

According to another preferred embodiment of the invention, the plate is a metal plate, preferably made of a copper alloy, because this material has a high thermal conductivity. Alternatively, other materials could be used such as silver alloys which have an even higher thermal conductively or steel or aluminum alloys which are less expensive.

According to another preferred embodiment of the invention, the plate has a thickness of 0,5 to 3 mm. A thickness of less than 0,5 mm restricts the thermal flow too much. A thickness of more than 3 mm increases the weight too much. A preferred thickness is app. 0,7 - 1,5 mm.

According to another preferred embodiment of the invention, the heat conducting element comprises a thermal insulation layer on the side opposite to the container, which is on the outside. This allows that all heat from the phase change material is directed through the heat conducting element to the surface subjected to thermal exposure so that the losses due to heat loss are minimized.

According to another preferred embodiment of the invention, the side of said container opposing said surface is thermoconductively connected to one side of a thermoelectric generator, its second side being thermoconductively connected to a heat sink device. This arrangement is specifically useful to extend the time of energy production. If the heat sink device is kept at a temperature above the phase change point of the phase change material while at the same time the surface temperature is below the phase change point, additional heat can be transferred into the phase change material which delays the moment when all of the phase change material is solidified. This extends the total amount of energy obtained. Alternatively, if the surface temperature is above the phase change point then the temperature of the heat sink device should be kept below the phase change point of the phase change material.

According to another preferred embodiment of the invention, a base plate is thermoconductively attachable to said surface which is connected to said first thermoelectric generator and to said at least one heat conducting element. Preferably, the heat conducting element and the plate together form a closed container which surrounds the container containing the phase change material. The space between the containers should be made up of one or plural thermoelectric generators.

According to another preferred embodiment of the invention, the container and the surrounding heat conducting element have a hexagonal cross section. In this case, a number of devices can be arranged beside one another, preferably in a honeycomb arrangement. This allows a optimal use of the required space leaving no waste space as the heat conducting elements of adjacent devices lie next to one another and touch one another so as to provide heat conducting structures with twice the width of one heat conducting element. The apparatus can be of modular structure so that an appropriate number of devices for achieving a desired electrical energy production can easily be combined.

According to another preferred embodiment of the invention, the phase change materials of different devices have different phase change points. This has the advantage that one unique device can be used for different flight profiles, covering even unconventional ones such as lift-off and landing in the Arctic region or very short flights, where the temperature does not decrease so much. Doing so, the complete device does not have to be replaced once the aircraft is exposed to different flight routes. The device containing different phase change materials with different phase change temperatures is able to cover various temperature profiles or flight profiles.
According to another preferred embodiment of the invention, an aircraft with a fuselage is provided, wherein the surface subjected to thermal exposure is a part of the aircraft fuselage. The device or multiple devices are attached to the inside surface of the fuselage.

Some embodiments of the invention will be described hereinafter with reference to the accompanying drawings in which
- Figure 1:: is a schematic cross sectional view of a generator device according to an embodiment of the invention;
- Figure 2:: a schematic top view of a generator device according to another embodiment of the invention;

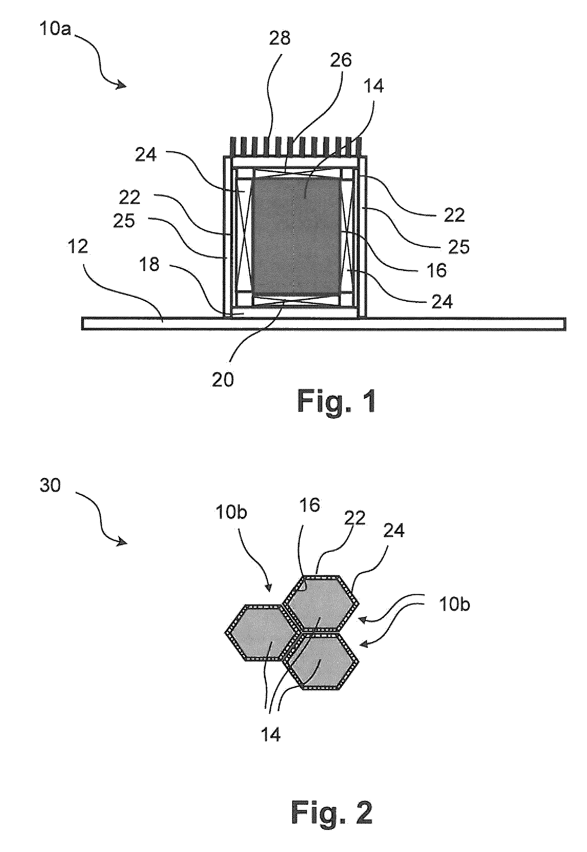

Figure 1 shows a schematic cross sectional view of a generator device 10a which is attached to a surface 12 subjected to thermal exposure. In this respect, thermal exposure should be understood as being a temperature which changes in respect of the freezing temperature of a phase change material 14 which is held in a container 16. The surface 12 will be subjected to a temperature higher or lower than the freezing temperature for a considerable time. The surface 12 will follow temperature changes relatively quickly, depending on material and size. In case the temperature at the surface passes the freezing or melting point of the phase change material, the phase change material causes a bigger delay in following the surface 12 temperature due to the melting or freezing process. This difference finally increases the amount of energy harvested.

Attached to the surface 12 is a base plate 18 of the generator device 10a which is in thermoconductive contact with the surface 12. The side of the base plate 18 opposite to the surface 12 is thermoconductively coupled to a first thermoelectric generator 20 which converts heat (i.e. a temperature differences) of two opposing sides directly into electrical energy, using a phenomenon called the thermoelectric effect. The first thermoelectric generator 20 and all other thermoelectric generators are electrically coupled to appropriate devices for converting the electrical energy to specific needs. These can be sensors and/or transmitters with low energy consumption or energy storing devices such as rechargeable batteries or supercapacitors, or a combination of both.

The second side of the first thermoelectric generator 20 is thermoconductively coupled to the container 16 holding the phase change material 14. In a preferred embodiment, the phase change material 14 is water.

Furthermore, also attached to the base plate 18 is a heat conducting element 22 which is shaped preferably as a plate which surrounds the container 16. In the space between the heat conducting element 22 and the container 16, at least one additional thermoelectric generator 24 is provided. Preferably, a number of additional thermoelectric generators 24 are provided. The outside of the heat conducting element 22 may be covered with an insulation layer 25 which reduces any heat flow from the device 10a to the outside or vice versa.

In the shown embodiment of Figure 1, the side of the container 16 opposite to the surface 12 is in contact with a third thermoelectric generator 26 which is thermoconductively coupled to a heat sink device 28.

For operation, a steady state temperature of 20°C will be assumed on the side of the surface 12 opposing the device 10a and also as the temperature of the phase change material 14. It is further assumed that the temperature of the surface 12 quickly drops to -20°C. The temperature of the base plate 18 quickly follows the temperature of the surface 12. As the temperature of the phase change material 14 initially remains at +20°C, this temperature gradient on both sides of the first thermoelectric generator 20 produces an electric current in the first thermoelectric generator 20. In order to utilize this, the first thermoelectric generator 20 is connected to appropriate electrical devices not shown. The heat from phase change material 14 thus flows through the first thermoelectric generator 20, the base plate 18 and the surface 12 which leads to a temperature decrease of the phase change material 14 until the phase change point of the phase change material 14 is reached. At the same time, heat also flows from the interior of the container 16 through the second thermoelectric generators 24 into the heat conducting element 22 and from there to the base plate 18 and the surface 12. Thus, a very large fraction of stored heat of the phase change material 14 is utilized for generating electrical energy which increases the efficiency of the device.

The surface of the container 16 opposite to the surface 10a which is connected to a heat sink device 28 through the third thermoelectric generators 26 may introduce additional thermal energy into the container 16 to increase the amount of produced electrical energy if the temperature of the heat sink device 28 is higher than that of the phase change material 14.

As long as not all of the phase change material 14 has solidified, there is a steady state of electrical energy production if the surface temperature remains unchanged as the temperature of the phase change material 14 does not change. Only after all phase change material 14 has solidified, its temperature decreases and the production of electrical energy decreases to 0.

Figure 2 shows a schematic top view of a generator apparatus 30 according to another embodiment of the invention. In this embodiment, the device 10b has a hexagonal cross section, i.e. both the containers 16 and the surrounding heat conducting elements 22 have a hexagonal cross section. In the space between each container 16 and heat conducting elements 22 second thermoelectric generators 24 are arranged. This arrangement allows a very efficient usage of available space and low thermal and accordingly electrical losses. Figure 2 shows only three hexagonal devices 10b. In practice, a larger number of hexagonal devices 10b will be combined into a generator apparatus 30, for example 9 - 30 devices.
- 10a, b: generator device
- 12: surface
- 14: phase change material
- 16: container
- 18: base plate
- 20: first thermoelectric generator
- 22: heat conducting element
- 24: second thermoelectric generator
- 25: insulation layer
- 26: third thermoelectric generator
- 28: heat sink device
- 30: generator apparatus

## Claims

1. A device (10) for generating electrical energy comprising at least a first thermoelectric generator (20) arranged between a surface (12) subjected to thermal exposure and a container (16) containing a phase change material (14), wherein the container (16) is surrounded by at least one heat conducting element (22) **characterized in that** the at least one heat conducting element (22) is thermoconductively connected to said surface (12) and is thermoconductively connected to the circumference of said container (16) through at least one second thermoelectric generator (24).

2. The device of claim 1, **characterized in that** said phase change material (14) contains water.

3. The device of any of the preceding claims, **characterized in that** said heat conducting element (22) comprises a plate.

4. The device of any of the preceding claims, **characterized in that** said heat conducting element (22) surrounds said container (16).

5. The device of claim 3 or 4, **characterized in that** said plate is a metal plate, preferably made of a copper alloy.

6. The device of claim 5, **characterized in that** said plate has a thickness of 0,5 to 3 mm.

7. The device of any of the preceding claims, **characterized in that** said heat conducting element (22) comprises a thermal insulation layer on the side opposing said container (16).

8. The device of any of the preceding claims, **characterized in that** the side of said container (16) opposing said surface (12) is thermoconductively connected to one side of a third thermoelectric generator (26), its second side being thermoconductively connected to a heat sink device (28).

9. The device of any of the preceding claims, comprising a base plate (18) thermoconductively attachable to said surface (12) which is connected to said first thermoelectric generator (20) and to said at least one heat conducting element (22).

10. The device of any of the preceding claims, **characterized in that** said container (16) and the surrounding heat conducting element (22) have a hexagonal cross section.

11. An apparatus for generating electrical energy, comprising plural devices according to claim 7 arranged in a honeycomb arrangement.

12. The apparatus of claim 11, **characterized in that** the phase change materials (14) of different devices (10) have different phase change points.

13. Aircraft with a fuselage, wherein said surface is part of said fuselage and at least one of said device according any of claims 1 to 10 is attached to the inside of said fuselage.

## Patentansprüche

1. Vorrichtung (10) zum Erzeugen elektrischer Energie, die mindestens einen ersten thermoelektrischen Generator (20) umfasst, der zwischen einer Oberfläche (12), die Wärmeexposition unterliegt, und einem Behälter (16), der ein Phasenwechselmaterial (14) enthält, eingerichtet ist, wobei der Behälter (16) von mindestens einem wärmeleitenden Element (22) umgeben ist, **dadurch gekennzeichnet, dass** das mindestens eine wärmeleitende Element (22) wärmeleitend mit der Oberfläche (12) verbunden ist und wärmeleitend mit dem Umfang des Behälters (16) durch mindestens einen zweiten thermoelektrischen Generator (24) verbunden ist.

2. Vorrichtung nach Anspruch 1, **dadurch gekennzeichnet, dass** das Phasenwechselmaterial (14) Wasser enthält.

3. Vorrichtung nach einem der vorhergehenden Ansprüche, **dadurch gekennzeichnet, dass** das wärmeleitende Element (22) eine Platte umfasst.

4. Vorrichtung nach einem der vorhergehenden Ansprüche, **dadurch gekennzeichnet, dass** das wärmeleitende Element (22) den Behälter (16) umgibt.

5. Vorrichtung nach Anspruch 3 oder 4, **dadurch gekennzeichnet, dass** die Platte eine Metallplatte ist, die vorzugsweise aus einer Kupferlegierung hergestellt ist.

6. Vorrichtung nach Anspruch 5, **dadurch gekennzeichnet, dass** die Platte eine Stärke von 0,5 bis 3 mm hat.

7. Vorrichtung nach einem der vorhergehenden Ansprüche, **dadurch gekennzeichnet, dass** das wärmeleitende Element (22) eine Wärmeisolationsschicht auf der Seite, die dem Behälter (16) entgegengesetzt ist, umfasst.

8. Vorrichtung nach einem der vorhergehenden Ansprüche, **dadurch gekennzeichnet, dass** die Seite des Behälters (16), die der Oberfläche (12) entgegengesetzt ist, wärmeleitend mit einer Seite eines dritten thermoelektrischen Generators (26) verbunden ist, wobei seine zweite Seite wärmeleitend mit einer Wärmesenkenvorrichtung (28) verbunden ist.

9. Vorrichtung nach einem der vorhergehenden Ansprüche, die eine Grundplatte (18) umfasst, die wärmeleitend mit der Oberfläche (12) verbunden werden kann, die mit dem ersten thermoelektrischen Generator (20) und mit dem mindestens einen wärmeleitenden Element (22) verbunden ist.

10. Vorrichtung nach einem der vorhergehenden Ansprüche, **dadurch gekennzeichnet, dass** der Behälter (16) und das umgebende wärmeleitende Element (22) einen sechseckigen Querschnitt haben.

11. Gerät zum Erzeugen elektrischer Energie, das mehrere Vorrichtungen nach Anspruch 7 in einer Wabenanordnung eingerichtet umfasst.

12. Gerät nach Anspruch 11, **dadurch gekennzeichnet, dass** die Phasenwechselmaterialien (14) unterschiedlicher Vorrichtungen (10) unterschiedliche Phasenwechselpunkte haben.

13. Luftfahrzeug mit einem Rumpf, wobei die Oberfläche Teil des Rumpfs ist und mindestens eine Vorrichtung nach einem der Ansprüche 1 bis 10 an der Innenseite des Rumpfs befestigt ist.

## Revendications

1. Dispositif (10) de génération d'énergie électrique comprenant au moins un premier générateur thermoélectrique (20) disposée entre une surface (12) soumise à une exposition thermique et un conteneur (16) contenant un matériau de changement de phase (14), dans lequel le conteneur (16) est entouré par au moins un élément de conduction thermique (22), **caractérisée en ce que** au moins un élément de conduction thermique (22) est connecté de manières thermoconductrice à ladite surface (12) est connecté de manières thermoconductrice à la circonférence dudit conteneur (16) par l'intermédiaire d'au moins un second générateur thermoélectrique (24).

2. Dispositif selon la revendication 1, **caractérisé en ce que** ledit matériau de changement de phase (14) contient de l'eau.

3. Dispositif selon une quelconque des revendications précédentes, **caractérisé en ce que** ledit élément de conduction thermique (22) comprend une plaque.

4. Dispositif selon une quelconque des revendications précédentes, **caractérisé en ce que** ledit élément de conduction thermique (22) entoure ledit conteneur (16).

5. Dispositif selon la revendication 3 ou 4, **caractérisé en ce que** ladite plaque est une plaque métallique, de préférence constituée d'un alliage de cuivre.

6. Dispositif selon la revendication 5, **caractérise en ce que** ladite plaque et l'épaisseur de 0,5 à 3 mm.

7. Dispositif selon une quelconque des revendications précédentes, **caractérisée en ce que** ledit élément de conduction thermique (22) comprend une couche d'isolation thermique sur le côté opposé au dit conteneur (16).

8. Dispositif selon une quelconque des revendications précédentes, **caractérisé en ce que** le côté dudit conteneur (16) opposée à ladite surface (12) est connecté de manière thermoconductrice à un côté d'un troisième générateur thermoélectrique (26), son second côté étant connecté de manière thermoconductrice à un dispositif de puits thermique (28).

9. Dispositif selon une quelconque des revendications précédentes, comprenant une plaque de base (18) fixable de manière thermoconductrice à ladite surface (12) qui est connecté au dit premier générateur thermoélectrique (20) et à au moins un élément de conduction thermique (22).

10. Dispositif selon une quelconque des revendications précédentes, **caractérisé en ce que** ledit conteneur (16) et l'élément de conduction thermique (22) qui l'entoure ont une section transversale hexagonale.

11. Dispositif de génération d'énergie électrique, comprenant une pluralité de dispositifs selon la revendication 7 disposés dans une disposition en nid d'abeille.

12. Dispositif selon la revendication 11, **caractérise en ce que** les matériaux de changement de phase (14) de différents dispositifs (10) ont des points de changement de phase différents.

13. Avon avec un fuselage, dans lequel ladite surface fait partie dudit fuselage et au moins un desdits dispositif selon une quelconque des revendications 1 à 10 est fixé à l'intérieur dudit fuselage.
